# EUROPEAN PATENT APPLICATION

(11) **EP 1 059 833 A2**
(43) Date of publication of application: **13.12.2000**
(21) Application number: 00304783.4
(22) Date of filing: 06.06.2000
(51) Int. Cl.: H05K 1/02, H05K 7/20

(54) **Heat transferring printed wiring board**

(30) Priority: 10.06.1999 US 329627
(71) Applicant: Xerox Corporation, Rochester, New York 14644 (US)
(72) Inventor: Dances, Robert J., Torrance, California 90503-6581 (US)
(74) Representative: Skone James, Robert Edmund

(57) **Abstract**

A heat transferring printed wiring board utilizes a plurality of printed heat conductive lines (24) to be bonded to each component (12) in order to transfer heat from each component to a heat sink (14). The heat conductive lines (24), which have connection to the components on the board, transfer the heat from each individual component (12) to the heat sink (14).

## Description

This invention relates to heat dissipation on printed wiring boards (PWB), and more particularly to surface mount printed wiring boards where the heat from each individual component is transferred to a heat sink.

In a printed wiring board where surface mount components are used, heat dissipation is a major problem. Surface mount components have a fraction of the size of regular electrical components. As a result, when surface mount components are used, a greater number of components are mounted at a close proximity of each other on the circuit board. The close proximity and the small sizes of the surface mount components prevent the heat generated in them to rapidly dissipate. This in turn causes the components to fail and cause the machine containing the circuit board to malfunction. For example, if the circuit board is used in a printer, the component failures may cause the printer to malfunction or the output to be misprinted.

A typical approach to resolve this problem is to direct a stream of air onto the circuit board to cool off the components. However, the location of the board in a complex mechanical machine such as a printer prevents the air to reach the tiny elements of the circuit board directly. Therefore, in the complex mechanical machines, the forced stream of air has not proven to be effective.

It is an object of this invention to provide a solution to cool off the surface mount components of a circuit board regardless of the design of the machine in which the circuit board is used.

According to the present invention, a printed wiring apparatus utilizes a plurality of printed conductive lines that are thermally connected to a heat transferring sheet for conducting heat into a heat sink.

According to another aspect of this invention, a printed wiring apparatus utilizes a printed wiring board (PWB) substrate which has a first surface a second surface, and a plurality of electrical conductive lines and a plurality of heat conductive lines on said first surface. Through a plurality of vias, the heat conductive lines are connected to a heat transferring sheet which is located on the second surface of the PWB substrate.

According to yet another aspect of this invention, a printed wiring apparatus utilizes a PWB substrate which has a thickness, a first surface, and a second surface. The first surface has a plurality of electrical conductive lines and a plurality of heat conductive line. The second surface has a plurality of electrical conductive lines and a plurality of heat conductive islands. The plurality of heat conductive lines are thermally connected to the plurality of heat conductive islands through the thickness of the PWB substrate. The heat conductive islands are also thermally connected to a heat transferring sheet.

According to further aspect of this invention, a printed wiring apparatus utilizes a PWB substrate which has a thickness, a first surface, and a second surface. The first surface has a plurality of electrical conductive lines and a plurality of heat conductive line. The second surface has a plurality of electrical conductive lines and a plurality of heat conductive islands. The plurality of heat conductive lines are thermally connected to the plurality of heat conductive islands through the thickness of the PWB substrate. The heat conductive islands are also thermally connected to a heat transferring sheet through gold bonding.

Some examples of apparatus according to the present invention will now be described with reference to the accompanying drawings, in which:-
Figure 1 shows a cross sectional view of a portion of the heat transferring printed wiring board of this invention;
Figure 2 shows a surface mount component of this invention;
Figure 3 shows a portion of the top view of heat transferring printed wiring board of this invention;
Figure 4 shows a cross sectional view of Figure 3 along line 4-4;
Figure 5 shows how a surface mount component is placed and bonded onto the heat transferring printing wiring board of this invention; and
Figure 6-9 show alternative HTPWBs of this invention.

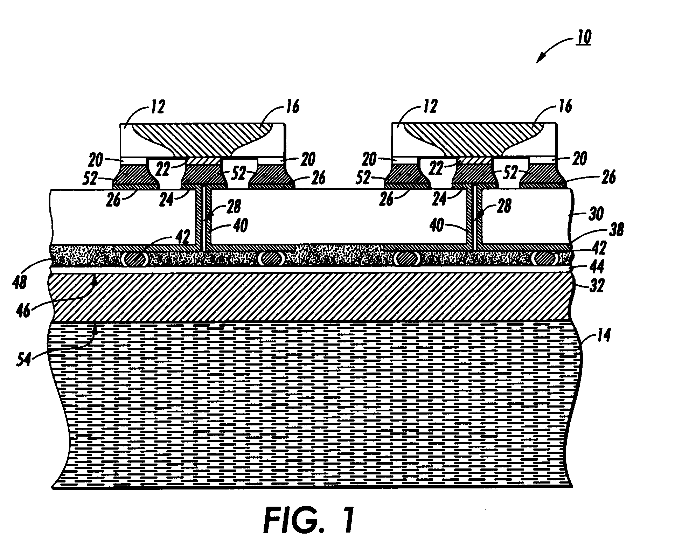

Referring to Figure 1, there is shown a portion of a cross sectional view of the heat transferring printed wiring board (HTPWB) 10 of this invention which incorporates a heat sinking mechanism for each individual component 12 on the board 10. The HTPWB 10 of this invention is used in a printing system where the HTPWB 10 is placed in contact with an aqueous ink reservoir 14. Each component 12 on the HTPWB 10 has a heat transferring pathway through a plurality of layers of the HTPWB 10 to the reservoir 14 which acts as a heat sinks. It should be noted that in this specification "heat sink" shall mean "a medium that absorbs heat and keeps its surroundings cool". In this invention, the conventional surface mount components and the printed wiring board are redesigned to accommodate heat transferring pathways.

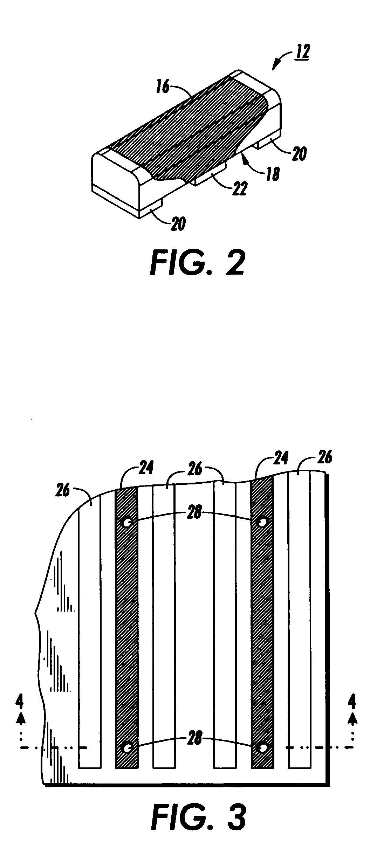

Referring to Figure 2, there is shown a surface mount component 12 of this invention. It should be noted that hereinafter, for the purpose of simplicity, "surface mount component" is referred to as "component". In this invention, each individual component has an external cladding 16 which is created by metal vapor plating method. However, any method that can create an external metal cladding, can replace the vapor plating used in this invention.

Cladding 16, which is made of copper with tin lead or gold for reliable solder connection, can have any shape and can cover any side of the component except on surface 18, where it has to be spaced from the electrical bonding pads (terminals) 20 of the component. On surface 18, cladding 16 creates a heat transferring bonding pad (terminals) 22.

It should be noted that the cladding 16 of this invention can also be utilized for purposes different than heat transfer. The metal vapor plated cladding 16 on a surface mount component can be utilized as a shield to reduce electromagnetic radiation both out of the component and into the component. Typically when a component is used in a high frequency application, the component might radiate electromagnetic waves which can affect the function of the neighboring components or the component might receive electromagnetic radiation which can affect its function. Since surface mount components are small, placing an external cladding on the component is not feasible. However creating a cladding via metal vapor provides a method to shield the surface mount components from the electromagnetic radiation in addition to transferring heat from each individual component.

The metal vapor plating used in creating cladding 16 can also be used to create a cladding on the packages of electronic chips to either transfer heat from the chip or prevent radiation effects from or to the chip. However, it should be noted if the cladding is used for heat dissipation, the component body or the chip packaging have to be heat conductive materials. In addition, the component body or the packaging of the chip have to be of such a material that metal vapor plating would adhere to them.

Referring to Figure 3, there is shown a portion of the top view of HTPWB 10 of this invention. The HTPWB 10 has a plurality of the heat conductive lines 24 and a plurality of electrical conductive lines 26. The heat conductive lines 24 are printed on the substrate 30 specifically to transfer heat.

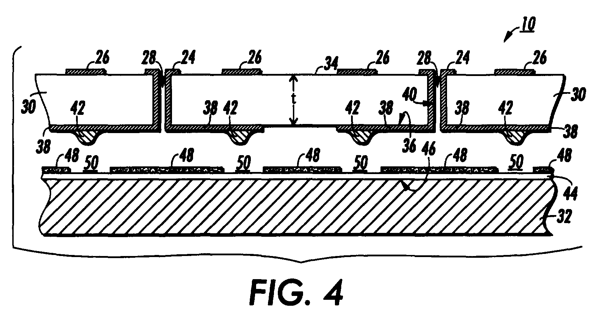

Referring to Figure 4, there is shown a cross sectional view of Figure 3 along the line 4-4. The HTPWB 10 of this invention is made of printed wiring board (PWB) substrate 30 and a copper beryllium plate 32 which are attached to each other. However, in Figure 4, the PWB substrate 30 and the copper beryllium plate 32 are shown as detached to depict the attaching process.

As shown in both Figures 3 and 4, each heat conductive line 24 has a plurality of holes (vias) 28 which extend through the thickness t of the PWB substrate 30 and create opening from surface 34 to surface 36. The heat conductive lines 24 on surface 34 and a plurality of copper islands 38 on surface 36 are created by printing or plating techniques which are well know techniques in the industry. Subsequently, copper plating process is used to create a layer 40 within the holes 28. The heat conductive lines 24 are connected to the copper islands 38 through the layer 40 in the holes 28.

The PWB substrate 30 has a plurality of electrical conductive lines 26 on surface 36 which are connected to the electrical conductive lines 26 of surface 34 by vias that extend through the thickness t of the substrate 30. For the purpose of simplicity, the vias for the electrical conductive lines 26 are not shown. The electrical conductive lines 26 and the vias are made by the industry well known techniques (printed and plating). The heat conductive lines, the copper islands 38, the holes 28, and the copper layer 40 do not have any contact to any of electrical conductive lines 26 on either surface or their vias.

To create a reliable heat transferring pathway between the PWB substrate 30 and the copper beryllium plate 32 a gold connection has to be created. Using gold plating process, a plurality of 6 mil high gold bumps 42 are created on the copper islands 38 of the PWB substrate 30 and a gold plated layer 44 is created on surface 46 of the copper beryllium plate 32.

To attach the PWB substrate 30 to the copper beryllium plate 32, a 2 mil thick layer of adhesive 48 is applied to the gold layer 44 through a mask to leave given areas 50 without adhesive. Next, the gold bumps 42 are placed in the open areas 50 and thermal pressure is applied to the PWB substrate 30 and the copper beryllium plate 32. Thermal pressure causes the soft gold bumps 42 to expand and bond to the gold layer 44 and causes the adhesive 48 to expand and attach the PWB substrate to the gold layer 44. However, after expansion, the adhesive 48 should not touch the gold bumps 42 to prevent bonding contamination between the gold bumps 42 and the gold layer 44.

Therefore, in this process, the amount and placement of adhesive is critical in providing an optimum connection in the bonding between the gold bumps 42 and the gold layer 44. The combination of the PWB substrate 30 and the copper beryllium plate 32 create the heat transferring printed wiring board (HTPWB) 10 of this invention.

In this invention, instead of copper, copper beryllium plate 32 is used to provide rigidity and reliable bonding to the gold layer 44. Also, in this invention, gold bumps 42 and the gold layer 44 are used since gold is readily deformed under pressure and provides a superb heat transfer pathway.

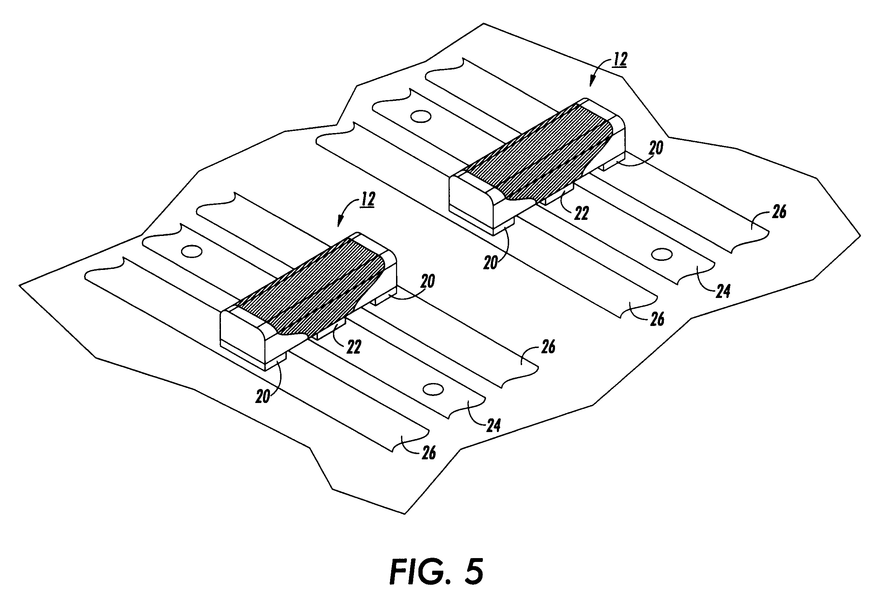

Referring to Figure 5, there is shown how surface mount components 12 are placed and bonded onto the HTPWB 10 of this invention. In Figure 5, when a component 12 is placed on a HTPWB 10, the electrical bonding pads 20 of the component 12 are placed on and bonded to the electrical conductive lines 26. However, the heat transferring bonding pad 22 are placed on and bonded to the heat conductive lines 24. The bonding between the electrical bonding pads 20 and heat transferring bonding pads 22 and their respective lines 26 and 24 is accomplished via a layer of solder 52 (Figure 1) which is created through solder reflow process.

Referring back to Figure 1, in a printing system, the HTPWB 10 of this invention is placed in such a manner that surface 54 of HTPWB 10 contacts a reservoir 14 of aqueous ink which acts as a heat sink. In operation, the cladding 16 transfers the heat from the components 12 to the heat conductive lines 24 from which the heat is transferred through the holes 28, to the copper islands 38. Then, from the copper islands 38, the heat is transferred through the gold bumps 42, the gold layer 44, the copper beryllium plate 32 into the ink reservoir 14.

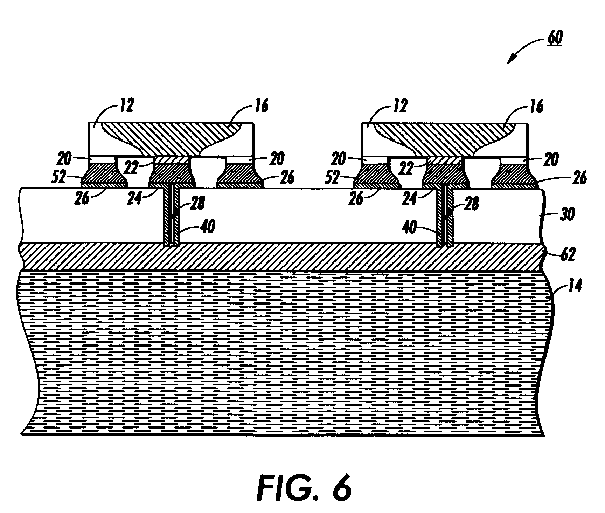

Referring to Figure 6, there is shown an alternative HTPWB 60 of this invention. In Figure 6, all the elements that are the same and serve the same purpose as the elements in Figure 1 are designated by the same reference numerals. In Figure 6, there are no electrical conductive lines on surface 36. As a result, a sheet 62 of heat transferring material such as aluminum is attached to the surface 36 of the PWB substrate 30. However, the aluminum sheet 62 must have a suitable coating to prevent galvanic action. The copper layer 40 in the holes 28 extend beyond the PWB substrate 30 by about 1 mil to contact the aluminum sheet 62. Another method to provide sufficient thermal contact between the copper layer 40 and the aluminum sheet 62 is to apply thermal joint compound between the PWB substrate 30 and the aluminum sheet 62.

In operation, the heat from the components 12 travel to the heat conductive lines 24, to the copper layer 40, to the aluminum sheet 62 from which it sinks into the aqueous ink reservoir 14.

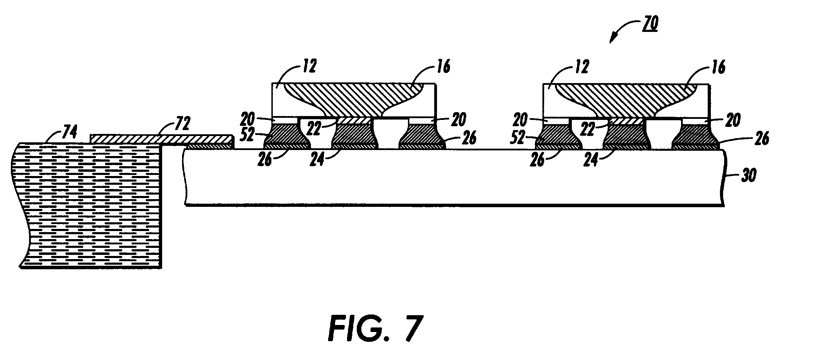

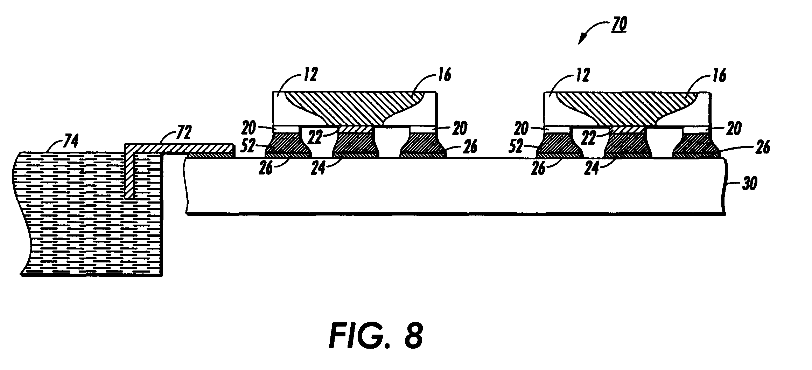

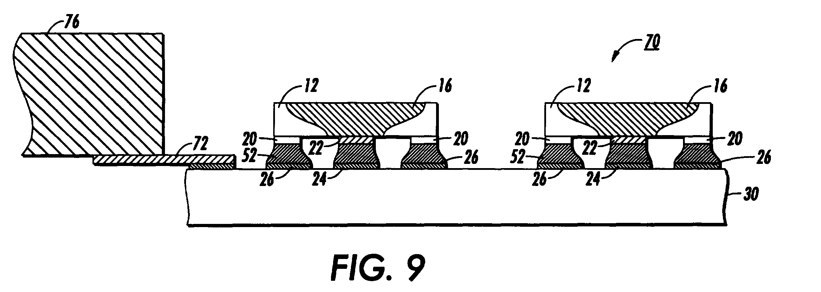

Referring to Figure 7, there is shown another alternative HTPWB 70 of this invention. In Figure 7, all the elements that are the same and serve the same purpose as the elements in Figure 1 are designated by the same reference numerals. In Figure 7, the heat conductive lines 24 are bonded to a sheet of material such as aluminum 72 which is placed in contact with a heat sink 74 such as aqueous ink reservoir 14. The sheet of aluminum 72 can be located at the edge of the HTPWB 70 in different shapes or can have contact with a heat sink 74 in different manners such as the ones shown on Figures 8 and 9. It should be noted that the heat sinks 74 and 76 shown in Figures 7-9 can be liquid or solid depending on the position and the manner used.

It should be noted that in the preferred embodiment of this invention an aqueous ink is utilized for its heat sink properties. However, any medium that can act as a heat sink can replace the aqueous ink used in this invention. As a result, the HTPWB 10 of this invention can be utilized in any system other than a printing system.

## Claims

1. A heat transferring printed wiring apparatus comprising:
a printed wiring substrate having a plurality of electrical conductive means and a plurality of heat conductive means;
means for transferring heat into a heat sink; and
said plurality of heat conductive means being thermally connected to said heat transferring means for conducting heat into said heat transferring means.

2. The heat transferring printed wiring apparatus recited in claim 1, further comprising;
an electronic component a plurality of electrical terminals means, a cladding and a cladding terminal;
said cladding and said cladding terminal being isolated from said electrical terminals; and
said cladding terminal being bonded to one of said plurality of heat conductive means and said plurality of electrical terminals each being bonded to one of said plurality of electrical conductive means.

3. The heat transferring printed wiring apparatus recited in claim 1 or claim 2, wherein said plurality of heat conductive means are copper.
